# EUROPÄISCHE PATENTSCHRIFT

(11) **EP 1 713 124 B1**
(45) Veröffentlichungstag und Bekanntmachung des Hinweises auf die Patenterteilung: **02.12.2009**
(21) Anmeldenummer: 06007011.7
(22) Anmeldetag: 01.04.2006
(51) Int. Cl.: H01L 25/07, H01L 23/492, H05K 1/14, H05K 3/34, H01L 23/498, H05K 1/03, H05K 3/22

(54) **Leistungshalbleitermodul mit Verbindungsbahnen und mit Anschlusselementen, die mit den Verbindungsbahnen verbunden sind**
Power semiconductor module with connecting tracks and with connecting elements connected to the connecting tracks
Module semiconducteur de puissance avec des pistes de connexion et avec des éléments de connexion connectés aux pistes de connexion

(30) Priorität: 12.04.2005 DE 102005016650
(43) Veröffentlichungstag der Anmeldung: 18.10.2006
(73) Patentinhaber: Semikron Elektronik GmbH & Co. KG Patentabteilung, 90431 Nürnberg (DE)
(72) Erfinder: Steger, Jürgen, 91355 Hiltpoltstein (DE); Manz, Yvonne, 91085 Weisendorf (DE)

(56) Entgegenhaltungen:
- EP-A- 0 527 033
- DE-A1- 19 752 408
- US-B1- 6 365 965

## Beschreibung

Die Erfindung beschreibt ein Leistungshalbleitermodul bestehend aus einem Gehäuse mit Grundplatte oder zur Montage auf einem Kühlkörper und mindestens einem darin angeordneten elektrisch isolierenden Substrat. Dieses besteht seinerseits aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Vorteilhafterweise weist das Substrat auf seiner Unterseite eine flächige metallische Schicht, vergleichbar den Verbindungsbahnen, auf. Weiterhin weisen derartige Leistungshalbleitermodule Anschlusselemente für externe Last- und Hilfskontakte und zum Teil auch Verbindungselemente für Verbindungen im Inneren des Leistungshalbleitermoduls auf. Nach dem Stand der Technik sind hierfür stoffschlüssige Verbindungsvarianten, hauptsächlich ausgestaltet als Lötverbindungen aber auch als Klebeverbindungen, bekannt.

Leistungshalbleitermodule, die Ausgangspunkt dieser Erfindung sind, sind beispielhaft bekannt aus der DE 39 37 045 A1 oder der nicht vorveröffentlichten DE 10 2004 019 568 A1. In der DE 39 37 045 A1 ist ein Leistungshalbleitermodul in Form einer Halbbrückenschaltungsanordnung dargestellt. Dieses Leistungshalbleitermodul weist als externe Lastanschlusselemente für die beiden Gleichstromanschlüsse und für den Wechselstromanschluss flächig ausgestaltete Metallformkörper auf. Diese als Anschlussbänder ausgebildeten Metallformkörper sind zur Reduktion parasitärer Induktivitäten im Inneren des Moduls möglichst eng benachbart zueinander angeordnet. Bedingt durch die bandartige Ausgestaltung zur Reduktion der parasitären Induktivitäten weisen diese Anschlussbänder mehrere "Fußpunkte" zum Kontakt mit den Verbindungsbahnen des Substrats auf. Diese Fußpunkte weisen zueinander einen größeren Abstand im Vergleich zu ihrer eigenen lateralen Ausdehnung auf.

Die DE 10 2004 019 568 A1 zeigt eine ähnliche Ausgestaltung der Anschlusselemente eines Leistungshalbleitermoduls. Hierbei ist in der Umgebung der Fußpunkte der Anschlusselemente eine Vielzahl von Vertiefungen in der Leiterplatte des Substrats vorgesehen um überschüssige Lotmengen aufzunehmen. Hierbei ist der Fußpunkt des Anschlusselements ausgebildet als ein flächig ausgestalteter Teil des als Metallformteils ausgebildeten Anschlusselements, wobei diese Fläche parallel zum Substrat angeordnet ist.

Gemäß den als Stand der Technik genannten Druckschriften sind die Substrate derartiger Leistungshalbleitermodule ausgebildet als isolierende Substrat bestehend aus einem Isolierstoffkörper als Trägermaterial und zur elektrischen Isolierung zu einer Grundplatte oder zu einem Kühlkörper. Dieser Isolierstoffkörper besteht nach dem Stand der Technik aus einer Industriekeramik beispielhaft Aluminiumoxid oder Aluminiumnitrit. Auf diesem Isolierstoffkörper auf dessen der Grundplatte oder dem Kühlkörper abgewandten ersten Hauptfläche befinden sich eine Mehrzahl von gegeneinander elektrisch isolierten metallischen Verbindungsbahnen. Auf diesen wiederum sind die Leistungshalbleiterbauelementen angeordnet. Meist weist der Isolierstoffkörper auf seiner der Grundplatte oder dem Kühlkörper zugewandten zweiten Hauptfläche ebenfalls eine metallische Schicht gleichen Materials und gleicher Dicke wie die Verbindungsbahnen auf der ersten Hauptfläche auf. In der Regel ist diese Schicht allerdings nicht in sich strukturiert, da sie beispielhaft der Lötverbindung zu einer Grundplatte dient. Die Verbindungsbahnen sowie die metallische Schicht der zweiten Hauptfläche besteht vorzugsweise aus nach dem DCB (direct copper bonding) Verfahren aufgebrachten Kupfer.

Zur Verbindung der genannten Verbindungsbahnen mit den Leistungshalbleiterbauelementen sind Verbindungselemente angeordnet, die nach dem Stand der Technik als Metallformkörper oder als Drahtbondverbindungen ausgebildet sind. Weiterhin sind auf diesen Verbindungsbahnen und mit ihnen stoffschlüssig verbunden die Anschlusselemente, die ebenfalls als Metallformkörper ausgebildet sind, zur externen elektrischen Verbindung des Leistungshalbleitermoduls angeordnet. Sowohl die Anschlusselemente als auch die Verbindungselemente in Gestalt von Metallformkörpern bestehen vorzugsweise aus Kupfer, da dieses besonders vorteilhafte elektrische Eigenschaften aufweist. Zudem können diese Metallformkörper auf ihrer Oberfläche eine Schicht aus Zinn oder Silber zu Verbesserung der Löteigenschaften aufweisen.

Verbindungen zwischen den Verbindungsbahnen des Substrats und Anschluss- oder Verbindungselementen weisen den Nachteil auf, dass diese Verbindung mechanische Spannungen aufweist. Diese mechanischen Spannungen haben ihren Ursprung in der Temperaturbelastung des Leistungshalbleitermoduls. Derartige Leistungshalbleitermodule weisen beispielhaft Betriebstemperaturen zwischen -40°C und +90°C auf. Der thermische Ausdehungskoeffizient der Anschluss- und Verbindungselemente wird durch das verwendete Material, hier vorzugsweise Kupfer, bestimmt. Demgegenüber wird der thermische Ausdehnungskoeffizient des Substrats hauptsächlich durch den Isolierstoffkörper bestimmt. Durch die thermische Belastung des Leistungshalbleitermoduls und den wesentlich geringeren thermischen Ausdehungskoeffizient des Substrats verglichen mit demjenigen der Anschluss- und Verbindungselemente entstehen die mechanischen Spannungen in der Verbindungsstelle zwischen dem Substrat und dem Anschluss- bzw. Verbindungselement.

Weiterhin sind beispielhaft aus den Druckschriften DE 35 05 086 A1, DE 44 46 527 A1 und DE 101 03 084 A1 Anschluss- oder Verbindungselemente bekannt. Die genannten Druckschriften tragen allerdings keine weitergehenden Erkenntnisse bezüglich der Ausgestaltung derartiger Anschluss- oder Verbindungselemente im Sinne dieser Erfindung bei. Sie zeigen ausschließlich verschiedenen Ausgestaltungen des Verlaufs und der Fußpunkte der Anschlusselemente.

[7a] Die Druckschrift DE 197 52 408 A1 offenbart ein Anschlusselement, welches als ein Metallformteil ausgebildet ist und das auf einer Verbindungsbahn angeordnet ist und Kontaktflächen zu dieser Verbindungsbahn aufweist, wobei die Kontaktflächen als Teilkontaktflächen ausgebildet sind. Die Verbindung des Anschlusselementes mit den Verbindungsbahnen erfolgt löttechnisch.

Der Erfindung liegt die Aufgabe zugrunde eine stoffschlüssige Verbindung zwischen einem Anschluss- und / oder Verbindungselement und einer Verbindungsbahn eines Substrats vorzustellen, wobei das Anschluss- bzw. Verbindungselement geeignet zu der Verbindungsbahn angeordnet ist und die mechanischen Spannungen in dieser stoffschlüssige Verbindung wirksam reduziert werden.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einem Leistungshalbleitermodul mit einer Grundplatte oder zur direkten Montage auf einem Kühlkörper. Dieses Leistungshalbleitermodul weist mindestens folgende Komponenten auf: ein Gehäuse, Anschlusselemente für Last- und Hilfsanschlüsse, ein Substrat mit Verbindungsbahnen, ein Leistungshalbleiterbauelemente und Verbindungselemente.

Die Anschlusselemente für Last- und Hilfskontakte führen aus dem Gehäuse heraus und dienen der elektrischen Verbindung der im Gehäuseinneren angeordneten Komponenten. Das elektrisch isolierende zur Grundplatte oder zum Kühlkörper ausgebildete Substrat besteht seinerseits aus einem Isolierstoffkörper, vorzugsweise einer Industriekeramik, und hierauf auf dessen der Grundplatte oder dem Kühlkörper abgewandten ersten Hauptfläche befindlichen einer Mehrzahl von gegeneinander elektrisch isolierten metallischen Verbindungsbahnen. Auf diesen Verbindungsbahnen sind Leistungshalbleiterbauelemente angeordnet und schaltungsgerecht mit Verbindungsbahnen und / oder weiteren Leistungshalbleiterbauelementen und / oder Anschlusselementen verbunden. Weitere interne Verbindungselemente verbinden mindestens zwei Verbindungsbahnen miteinander oder mit Leistungshalbleiterbauelementen.

Mindestens eines dieser Anschluss- und / oder Verbindungselemente ist als Metallformteil mit mindestens einer Kontaktfläche zu einer Verbindungsbahn ausgebildet und stumpf, also ohne abgewinkelten flächigen Abschnitt parallel zum Substrat, zu dieser Verbindungsbahn angeordnet. Diese mindestens eine Kontaktfläche ist als eine Mehrzahl von Teilkontaktflächen ausgebildet, wobei jede Teilkontaktfläche einen maximalen Flächeninhalt von 20mm² aufweist und jeweils zwei Teilkontaktflächen einen maximalen Abstand von 5mm zueinander aufweisen.

Vorteilhaft an der genannten Ausgestaltung der Anschluss- und Verbindungselemente ist, dass die mechanischen Spannungen auf die Teilflächen verteilt werden und hierdurch die Dauerhaltbarkeit, bei thermischer Belastung des Leistungshalbleitermoduls, vergrößert wird. Speziell beim Einsatz bleifreier Lote, die in der Regel eine geringere Duktilität als bleihaltige Lote aufweisen, weist somit die erfindungsgemäße Verbindung zwischen dem Anschluss- oder Verbindungselement und der Verbindungsbahn geringere mechanische Spannungen und somit eine hohe Dauerhaltbarkeit auf.

Der erfinderische Gedanke wird anhand der Figuren 1 bis 4 näher erläutert. Erfindungsgemäß ist hierbei die Ausführung gemäß Fig. 3 in Verbindung mit Fig. 4d. Die übrigen Figuren dienen dem Verständnis der Erfindung.

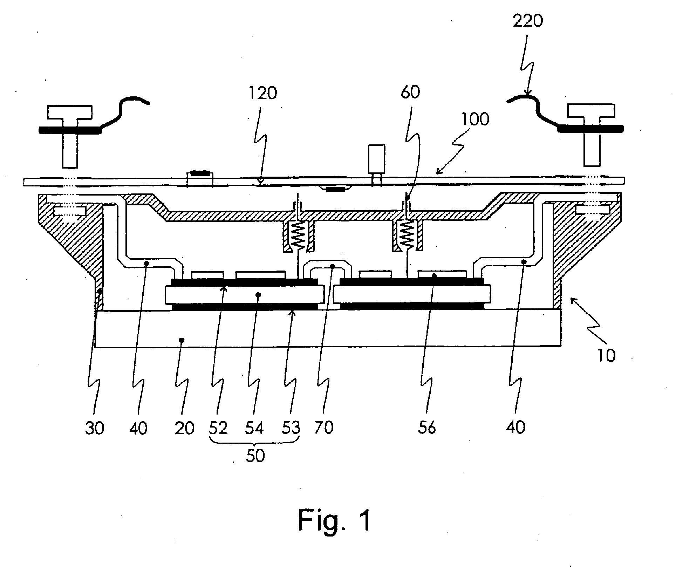

Fig. 1 zeigt ein Leistungshalbleitermodul mit stumpf angeordneten Anschlusselementen.

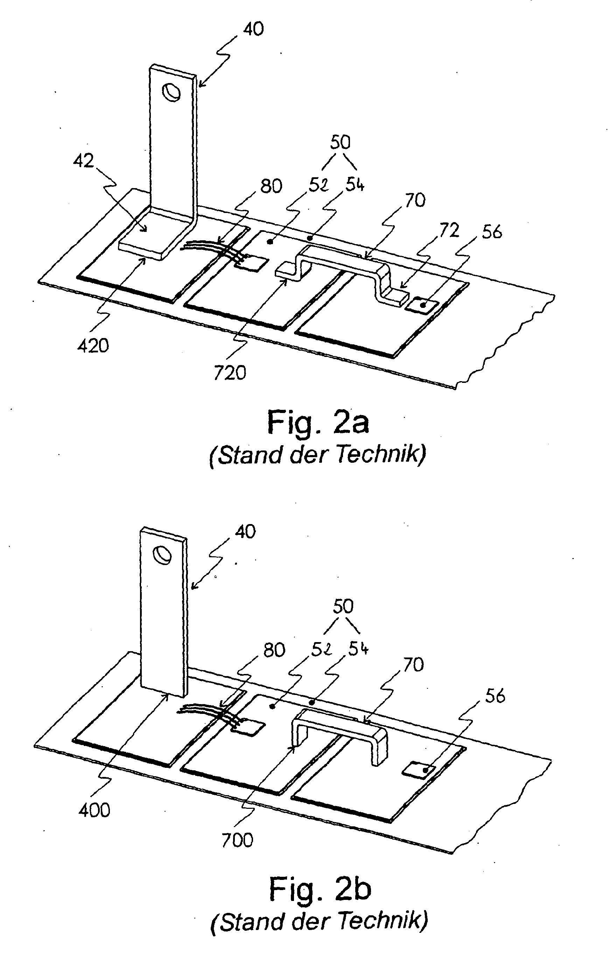

Fig. 2 zeigt Substrate mit Anschluss- und Verbindungselementen nach dem Stand der Technik.

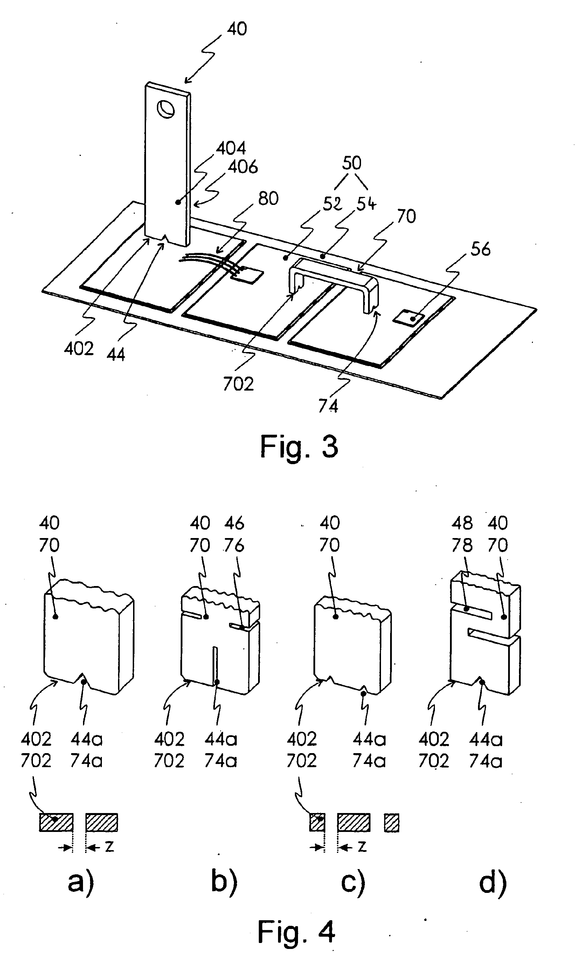

Fig. 3 zeigt ein Substrat mit erfindungsgemäßen Anschluss- und Verbindungselementen.

Fig. 4 zeigt spezielle Ausgestaltungen von Anschluss- und Verbindungselementen.

Fig. 1 zeigt ein Leistungshalbleitermodul (10) mit stumpf angeordneten Anschlusselementen. Dargestellt ist die Anordnung einer Leiterplatte (100) und eines Leistungshalbleitermoduls (10) in der Seitenansicht, wobei die Leiterplatte (100) und das Leistungshalbleitermodul (10) geringfügig beabstandet zueinander dargestellt sind. Das Leistungshalbleitermodul (10) selbst weist eine Grundplatte (20) auf. Hierauf angeordnet sind das rahmenartige Gehäuse (30) sowie die beiden Substrate (50). Jedes Substrat (50) besteht aus einem Isolierstoffkörper (54) sowie aus metallischen Kaschierungen, die auf beiden Hauptflächen angeordnet sind. Die der Grundplatte (20) zugewandte metallische Kaschierung (53) ist flächig ausgebildet und nicht strukturiert. Demgegenüber ist die dem Leistungshalbleitermodulinneren zugewandte Kaschierung in sich strukturiert und bildet somit die Verbindungsbahnen (52) des Substrats aus.

Auf diesen Verbindungsbahnen (52) sind die Leistungshalbleiterbauelemente (56) angeordnet. Die elektrischen Anschlusselemente bilden die Leistungs- (40) und die Hilfsanschlüsse (60). Die druckkontaktierten Hilfsanschlüsse (60) sind als Kontaktfedern ausgebildet und bedürfen einer Druckbeaufschlagung zur sicheren elektrischen Kontaktierung zwischen den Verbindungsbahnen (52) des Substrats (50) und zugeordneten Verbindungsbahnen (120) der Leiterplatte (100).

Die Anschlusselemente (40) der Leistungsanschlüsse werden gebildet durch Metallformteile, die an ihrem einen Ende löttechnisch mit der zugeordneten Verbindungsbahn (52) des Substrats (50) stumpf verbunden sind und an ihrem anderen Ende eine Ausnehmung zu Schraubverbindung aufweisen.

Das einstückig einen Rahmen und einen Deckel bildende Gehäuse (30) weist Ausformungen auf zur Positionierung und Fixierung der Leistungs- (40) und Hilfsanschlüsse (60). Die Leistungsanschlüsse werden jeweils in einer Ausformung des Gehäuses fixiert.

Die Leiterplatte (100) weist auf ihrer dem Leistungshalbleitermodul zugewandten Seite Verbindungsbahnen (120) auf. Diese bilden die Kontaktpunkte der Kontaktfedern und dienen somit der Verbindung zu den Verbindungsbahnen (52) des Substrats (50).

Die weiteren Anschlussverbindungen der Leistungsanschlüsse (40) zur Anbindung an den Gleichstromzwischenkreis und die Last sind hier als Kabelverbindungen (220) ausgebildet.

Fig. 2a zeigt ein Substrat (50) mit Anschluss- (40) und Verbindungselementen (70) nach dem Stand der Technik. Dargestellt sind hier der Isolierstoffkörper (54) des Substrats (50) sowie die hierauf ausgebildeten Verbindungsbahnen (52). Auf zwei dieser Verbindungsbahnen (52) ist jeweils ein Leistungshalbleiterbauelement (56) angeordnet. Eines dieser Leistungshalbleiterbauelemente (56) ist exemplarisch mittels Drahtbondverbindungen (72) mit einer benachbarten Verbindungsbahn (52) verbunden.

Auf dieser Verbindungsbahn (52) ist ein Anschlusselement (40) nach dem Stand der Technik angeordnet. Dieses Anschlusselement (40) ist als Metallformteil ausgebildet und weist einen Abschnitt (42) parallel zum Substrat (50) auf, welcher die Kontaktfläche (420) zum Substrat (50) bzw. zu dessen Verbindungsbahn (52) bildet. Dieser Abschnitt ist stoffschlüssig mittels einer nicht explizit dargestellten Lötverbindung mit der Verbindungsbahn (52) verbunden. Ein Verbindungselement (70) verbindet zwei Verbindungsbahnen (52) miteinander. Dieses Verbindungselement (70) ist ebenfalls als Metallformteil ausgebildet und weist an den Verbindungsstellen, den Kontaktflächen (720) zu den Verbindungsbahnen (52) ebenfalls jeweils einen zugehörigen Abschnitt (72) parallel zum Substrat (50) auf. In gleichartiger Ausführung sind auch Verbindungselemente (70) zwischen einer Verbindungsbahn (52) und einem Leistungshalbleiterbauelement seit langem bekannt, hier dargestellt ist die alternative Variante mittels einer Drahtbondverbindung (80).

Fig. 2b zeigt im Wesentlichen die gleiche Anordnung und die gleichen Komponenten wie Fig. 2a. Im Gegensatz zu Fig. 2a weisen die Anschluss- (40) und Verbindungselemente (70) hier keine Abschnitte parallel zum Substrat (50) auf. Hier sind die Anschluss- (40) und Verbindungselemente (70) stumpf mittels ihrer Kontaktflächen (400, 700) auf die Verbindungsbahnen (52) aufgelötet.

Fig. 3 zeigt ein Substrat (50) mit erfindungsgemäßen Anschluss- (40) und Verbindungselementen (70). Die wesentlichen Bestandteile, wie Substrat (50) und Leistungshalbleiterbauelemente (56) sind identisch denjenigen in Fig. 2a. Im Gegensatz zu Fig. 2b sind hier die Anschluss- (40) und Verbindungselemente (70) erfindungsgemäß weitergebildet. Das Anschlusselement (40) ist ebenfalls stumpf auf die Verbindungsbahn (52) gelötet. Allerdings ist die Kontaktfläche zwischen Anschlusselement (40) und Verbindungsbahn (52) nicht als eine durchgängige Fläche ausgebildet sondern als zwei Teilflächen (402) ausgebildet.

Hierzu weist das Metallformteil des Anschlusselements (40) eine Ausnehmung (44) auf. Diese Ausnehmung (44) geht aus von der dem Substrat (50) zugewandten Fläche des Metallformteils und erstreckt sich dreieckförmig von der ersten (404) bis zur zweiten Hauptfläche (406). Hierbei ist der Flächeninhalt jeder Teilfläche (402) kleiner als 20mm² und der Abstand der Teilflächen (402) zueinander zwischen 1 mm und 5mm. Die stoffschlüssige Verbindung zwischen der Verbindungsbahn (52) und dem Anschlusselement (40) ist als Lötverbindung ausgebildet, wobei das Lot in die Ausnehmung (44) hineinreicht und somit diese annährend vollständig oder vollständig verfüllt.

In gleicher Weise ist auch das Verbindungselement (70) ausgebildet. Hierbei weisen die Kontaktflächen ebenfalls eine Aufteilung in zwei Teilkontaktflächen (702), mit jeweils einer dreieckförmigen Ausnehmung (74), auf.

Fig. 4 zeigt beispielhaft spezielle Ausgestaltungen von Teilen der Anschluss- (40) oder Verbindungselemente (70). Fig. 4a zeigt eine Ausgestaltung der Ausnehmung (44a) gemäß Fig. 3, wobei hier allerdings die schmalen Kanten zusätzlich angephast sind. Weiterhin sind hier die einzelnen Teilkontaktflächen (402, 702) in Draufsicht sowie deren Abstand (1 mm ≤ z ≤ 5mm) zueinander dargestellt.

Fig. 4b zeigt eine schlitzförmige Ausgestaltung der Ausnehmung (44a, 74a) des Anschluss- (40) bzw. Verbindungselements (70). Hierbei ist der Schlitz lotrecht von der Kontaktfläche ausgehend ausgebildet. Ein derartiger Schlitz (44a, 74a) wird bei der Lötverbindung vorteilhafterweise nicht vollständig mit Lot verfüllt. Von der Kontaktfläche beanstandet weist das Metallformteil als Einschnürung (46, 76) noch zwei weitere orthogonal zum ersten angeordnete Schlitze zum Ausgleich von Torsionskräften auf.

Fig. 4c zeigt eine Ausgestaltung eines Anschluss- (40) bzw. Verbindungselements (70) mit zwei Ausnehmungen (44a, 74a) gemäß Fig. 4a. Eine Mehrzahl derartiger Ausnehmungen (44a, 74a) verringert die mechanischen Spannungen weiter. Allerdings ist auch ein minimaler Flächeninhalt der Teilflächen von 4mm² vorteilhaft. Die einzelnen Kontaktflächen (402, 702) sind wiederum in Draufsicht dargestellt, sowie deren Abstand (1mm ≤ z ≤ 5mm) zueinander.

Fig. 4d. zeigt ein Anschluss- (40) bzw. Verbindungselements (70) gemäß Fig. 4a, welches allerdings in definiertem Abstand von der Kontaktfläche zwei sich überlappende voneinander beabstandete Schlitze, die hier zwei Einschnürungen (48, 78) bilden und als Zugentlastung dienen, aufweist.

## Patentansprüche

1. Leistungshalbleitermodul (10) mit einer Grundplatte (20) oder zur direkten Montage auf einem Kühlkörper mindestens bestehend aus einem Gehäuse (30), nach außen führenden Anschlusselementen (40) für externe Lastkontakte, mindestens einem innerhalb des Gehäuses (30) angeordneten elektrisch isolierenden Substrat (50), das seinerseits besteht aus einem Isolierstoffkörper (54) und auf dessen der Grundplatte (20) oder dem Kühlkörper abgewandten ersten Hauptfläche befindlichen Mehrzahl von gegeneinander elektrisch isolierten metallischen Verbindungsbahnen (52), darauf befindlichen Leistungshalbleiterbauelementen (56) und Verbindungselementen (70), zwischen zwei Verbindungsbahnen (52) und / oder zwischen Verbindungsbahnen (52) und Leistungshalbleiterbauelementen (56),
wobei mindestens ein Anschluss- (40) und /oder Verbindungselement (70) als ein Metallformteil ausgebildet ist mit mindestens einem Endabschnitt, wobei jeder Endabschnitt lotrecht zu einer zugeordneten Verbindungsbahn (52) verläuft und mit einer Kontaktfläche mit dieser Verbindungsbahn (52) stumpf verlötet ist, wobei diese Kontaktfläche als eine Mehrzahl von Teilkontaktflächen (402, 702) ausgebildet ist, wobei jede Teilkontaktfläche (402, 702) einen maximalen Flächeninhalt von 20mm² aufweist, jeweils zwei Teilkontaktflächen (402, 702) einen maximalen Abstand von 5mm zueinander aufweisen, wobei der Endabschnitt des Anschluss- (40) und / oder Verbindungselements (70) in seinem Verlauf nahe benachbart zu den Kontaktflächen zwei in geringem Abstand zueinander angeordnete Einschnürungen (48, 78) aufweist, die von zwei sich überlappenden und voneinander beabstandeten Schlitzen geformt werden und wobei die Struktur mit diesen Einschnürungen und Schlitzen eine Zugentlastung für das Anschluss- (40) und / oder Verbindungselement (70) bildet.

2. Leistungshalbleitermodul (10) nach Anspruch 1,
wobei die Anschluss- (40) und / oder Verbindungselemente (70) als Metallformteile aus Kupfer mit einer Oberfläche aus Zinn oder Silber ausgebildet sind.

3. Leistungshalbleitermodul (10) nach Anspruch 1,
wobei die Teilkontaktflächen (402, 702) einen Abstand von 1 mm bis 5mm voneinander aufweisen.

4. Leistungshalbleitermodul (10) nach Anspruch 3,
wobei das Anschluss- (40) und / oder Verbindungselement (70) zwischen den Teilkontaktflächen (402, 702) Ausnehmungen (44a) aufweist, die dreieckig mit der Basis an der Kontaktfläche ausgebildet sind.

5. Leistungshalbleitermodul (10) nach Anspruch 3,
wobei das Anschluss- (40) und / oder Verbindungselement (70) zwischen den Teilkontaktflächen (402, 702) Ausnehmungen (44a) aufweist, die als Schlitze lotrecht von der Kontaktfläche ausgehend ausgebildet sind.

## Claims

1. A power semiconductor module (10) with a base plate (20), or for the purpose of direct assembly on a heat sink at least consisting of a housing (30), contact elements (40) leading outwards for external load contacts, at least one electrically insulating substrate (50) arranged within the housing (30), which in turn consists of an insulator body (54) and a plurality of metallic connection tracks (52) that are electrically insulated from each other located on its first main surface facing away from the base plate (20) or heat sink, power semiconductor components (56) and connecting elements (70) located thereon, between two connection tracks (52) and / or between connection tracks (52) and power semiconductor components (56),
wherein at least one contact element (40) and / or connecting element (70) is constructed as a metallic shaped part with at least one end section, wherein each end section extends perpendicularly to an associated connection track (52) and is butt soldered with at least one contact surface to this connecting track (52),
wherein this contact surface is constructed as a plurality of partial contact surfaces wherein each partial contact surface (402, 702) has a maximum surface area of 20mm2, and each pair of partial contact areas (402, 702) has a maximum separation of 5mm from each other, wherein the end section of the contact element (40) and / or connecting element (70) includes in its extent two constrictions (48, 78) closely neighbouring the contact surfaces and arranged a small distance apart, which are formed from two overlapping slits spaced apart from each other and wherein the structure with these constrictions and slits provides strain relief for said contact element (40) and / or connecting element (70).

2. The power semiconductor module (10) according to Claim 1,
wherein the contact element (40) and / or connecting element (70) are constructed as metallic shaped parts made of copper with a surface made of tin or silver.

3. The power semiconductor module (10) according to Claim 1,
wherein the partial contact surfaces (402, 702) are spaced apart from each another by a distance of 1mm to 5mm.

4. The power semiconductor module (10) according to Claim 3,
wherein the contact element (40) and / or connecting element (70) has recesses (44a) between the partial contact surfaces (402, 702), which are in the shape of a triangle with the base on the contact surface.

5. The power semiconductor module (10) according to Claim 3,
wherein the contact element (40) and / or connecting element (70) has recesses (44a) between the partial contact surfaces (402, 702), which extend in the form of slits perpendicularly away from the contact surface.

## Revendications

1. Module semiconducteur de puissance (10), avec une plaque de base (20) ou destiné à un montage direct sur un radiateur, se composant au moins d'un boîtier (30), d'éléments de raccordement (40) conduisant vers l'extérieur pour des contacts externes de charges, d'au moins un substrat électriquement isolant (50) monté à l'intérieur du boîtier (30) et se composant à son tour d'un corps en matière isolante (54) et, sur sa première face principale opposée à la plaque de base (20) ou au radiateur, d'une pluralité de pistes métalliques de liaison (52) isolées électriquement les unes des autres, de composants semiconducteurs de puissance (56) et d'éléments de liaison (70) se trouvant sur celles-ci, entre deux pistes de liaison (52) et/ou entre des pistes de liaison (52) et des composants semiconducteurs de puissance (56), dans lequel au moins un élément de raccordement (40) et/ou de liaison (70) prend la forme d'une pièce formée en métal avec au moins un segment d'extrémité, dans lequel chaque segment d'extrémité est disposé à l'aplomb d'une piste de liaison (52) correspondante et est soudé en bout par une surface de contact sur cette piste de liaison (52), dans lequel cette surface de contact prend la forme d'une pluralité de surfaces élémentaires de contact (402, 702), dans lequel chacune des surfaces élémentaires de contact (402, 702) possède une surface maximale de 20 mm², dans lequel les surfaces élémentaires de contact (402, 702) prises deux à deux ont une distance maximale de 5 mm entre elles, dans lequel le segment d'extrémité de l'élément de raccordement (40) et/ou de liaison (70) possède sur sa longueur, au proche voisinage des surfaces de contact, deux strictions (48, 78) placées à une faible distance l'une de l'autre et formées par deux fentes qui se recouvrent et qui sont écartées l'une de l'autre et dans lequel la structure composée de ces strictions et de ces fentes forme une décharge de traction pour l'élément de raccordement (40) et/ou de liaison (70).

2. Module semiconducteur de puissance (10) selon la revendication 1, dans lequel les éléments de raccordement (40) et/ou de liaison (70) sont constitués de pièces métalliques formées, faites de cuivre avec une surface en étain ou en argent.

3. Module semiconducteur de puissance (10) selon la revendication 1, dans lequel les surfaces élémentaires de contact (402, 702) présentent entre elles une distance de 1 mm à 5 mm.

4. Module semiconducteur de puissance (10) selon la revendication 3, dans lequel l'élément de raccordement (40) et/ou de liaison (70) possède entre les surfaces élémentaires de contact (402, 702) des encoches (44a) qui prennent une forme triangulaire avec la base à la surface de contact.

5. Module semiconducteur de puissance (10) selon la revendication 3, dans lequel l'élément de raccordement (40) et/ou de liaison (70) possède entre les surfaces élémentaires de contact (402, 702) des encoches (44a) qui prennent une forme de fentes verticales partant de la surface de contact.
